(19) Europäisches Patentamt
European Patent Office
Office européen des brevets

(11) **EP 3 526 871 B1**

(12) **FASCICULE DE BREVET EUROPEEN**

(45) Date de publication et mention
de la délivrance du brevet:
**30.09.2020 Bulletin 2020/40**

(51) Int Cl.:
*H02J 3/02* *(2006.01)*     *H01P 5/12* *(2006.01)*
*H03B 25/00* *(2006.01)*     *H03B 15/00* *(2006.01)*

(21) Numéro de dépôt: **17780447.3**

(86) Numéro de dépôt international:
**PCT/EP2017/075934**

(22) Date de dépôt: **11.10.2017**

(87) Numéro de publication internationale:
**WO 2018/069389 (19.04.2018 Gazette 2018/16)**

(54) **PROCÉDÉ DE GÉNÉRATION D'UNE PLURALITÉ DE COURANTS PRÉSENTANT CHACUN UNE FRÉQUENCE**

VERFAHREN ZUR ERZEUGUNG EINER VIELZAHL VON STRÖMEN MIT JEWEILS EINER FREQUENZ

METHOD FOR GENERATING A PLURALITY OF CURRENTS, EACH HAVING A FREQUENCY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **11.10.2016 FR 1601474**

(43) Date de publication de la demande:
**21.08.2019 Bulletin 2019/34**

(73) Titulaires:
• **Thales**
**92400 Courbevoie (FR)**
• **Centre National de la Recherche Scientifique**
**75016 Paris 16 (FR)**

(72) Inventeurs:
• **BORTOLOTTI, Paolo**
**91767 Palaiseau (FR)**
• **KERMORVANT, Julien**
**91767 Palaiseau (FR)**
• **CROS, Vincent**
**91767 Palaiseau (FR)**
• **MARCILHAC, Bruno**
**91767 Palaiseau (FR)**
• **LEBRUN, Romain**
**72000 Le Mans (FR)**

(74) Mandataire: **Lavoix**
**2, place d'Estienne d'Orves**
**75441 Paris Cedex 09 (FR)**

(56) Documents cités:
**FR-A1- 2 944 384     FR-A1- 2 977 999**
**FR-A1- 3 014 205**

EP 3 526 871 B1

**Description**

La présente invention concerne un procédé de génération d'une pluralité de courants présentant chacun une composante fréquentielle respective.

Les ondes électromagnétiques radiofréquences, également dénommées ondes radioélectriques, sont les ondes électromagnétiques dont la fréquence est prise entre 3 kiloHertz (kHz) et 100 GigaHertz (GHz). Les ondes radioélectriques sont utilisées dans de nombreuses applications. En particulier, certaines fréquences d'ondes radioélectriques sont très peu atténuées par l'atmosphère terrestre. Les ondes radioélectriques, et en particulier les ondes radioélectriques dont la fréquence est supérieure ou égale à 3 MegaHertz (MHz), sont donc fréquemment utilisées pour les applications de type télécommunication et/ou radar.

Il est fréquent qu'un seul dispositif générant un signal électrique radiofréquence alimente plusieurs appareils distincts. Par exemple, un signal reçu par un unique récepteur est fréquemment utilisé simultanément par plusieurs dispositifs de communication, ou un signal radiofréquence de référence est parfois utilisé lors de plusieurs étapes parallèles d'un procédé de traitement de signaux.

Il est ainsi souhaitable, à partir d'un seul signal radiofréquence, de générer une pluralité de signaux radiofréquences distincts pour alimenter ces différents appareils. Les signaux radiofréquences générés sont dans la plupart des cas destinés à transmettre aux différents appareils la même information du récepteur.

Dans ce but, des dispositifs nommés distributeurs sont présents dans de nombreuses installations, et permettent de générer, à partir d'un premier signal radiofréquence, un ensemble de signaux (en général des courants électriques) portant la même information, et en particulier présentant les mêmes fréquences que le signal d'origine.

Les distributeurs utilisés sont, en général, des diviseurs de puissances permettant de répartir le courant reçu en entrée entre différents ports de sortie. Cependant, ce type de distributeurs est encombrant et complexe à réaliser. De plus, une architecture de ce type impose une diminution importante de la puissance des signaux de sortie par rapport au signal d'entrée, ce qui risque de résulter en une perte d'informations dommageable. Un ou plusieurs amplificateurs sont en général employés. Il en résulte une augmentation de l'encombrement, de la complexité et du coût du système.

On identifiera ici les documents de brevets FR 2 977 999 A1 et FR 3 014 205 A1. En particulier le document FR 2 977 999 A1 décrit un oscillateur spintronique et l'utilisation de celui-ci dans des dispositifs radiofréquence. Cependant ce document, avec le vocabulaire des objets revendiqués ici, ne présente qu'une seul source de courant amenant à l'oscillation de chaque piliers. Il n'existe pas non plus de dispositif de réglage d'un champ d'excitation par un deuxième courant. En outre, Il n'y est pas explicitement cherché à fournir des courant de fréquences différentes à partie de source de courant différentes. Il n'est enfin pas question d'un rapport entre le double de la fréquence de résonance de chaque pilier du premier ensemble et la première fréquence étant égal, à dix pour cents près, à un premier nombre entier naturel.

Il existe donc un besoin pour un procédé permettant de générer une pluralité de signaux radiofréquences équivalents à partir d'un signal radiofréquence d'origine, qui soit de mise en oeuvre plus facile et diminue les dimensions du dispositif générant les signaux.

A cet effet, il est proposé un procédé de génération, à partir d'un premier courant électrique comportant au moins une première composante fréquentielle présentant une première fréquence, d'une pluralité de deuxièmes courants présentant chacun une deuxième composante fréquentielle respective, le procédé comprenant une étape de fourniture d'un distributeur de fréquence comportant un premier ensemble de piliers, chaque pilier comprenant un empilement de couches superposées selon une direction d'empilement. L'empilement comprend au moins une couche libre réalisée en un premier matériau magnétique, une couche fixe réalisée en un deuxième matériau magnétique, et une couche barrière réalisée en un troisième matériau non-magnétique, la couche barrière séparant la couche libre de la couche fixe selon la direction d'empilement. Le distributeur de fréquence comprend, en outre, au moins un organe de commande propre à générer un deuxième courant électrique, un organe de couplage, et une pluralité de conducteurs électriques de sortie, chaque conducteur électrique de sortie étant propre à alimenter un dispositif électrique avec un deuxième courant électrique respectif. Chaque pilier est propre, lorsque le pilier est traversé par un courant continu et n'est pas excité par l'organe de couplage, à générer dans le courant continu une troisième composante fréquentielle présentant une fréquence appelée fréquence de résonance dudit pilier. Le procédé comprend, en outre une étape de génération d'une pluralité de deuxièmes courants électriques, chaque pilier du premier ensemble étant traversé par un deuxième courant respectif selon la direction d'empilement, une étape d'excitation, par l'organe de couplage, de chaque pilier du premier ensemble avec un champ électromagnétique présentant la première fréquence, le rapport entre le double de la fréquence de résonance de chaque pilier du premier ensemble et la première fréquence étant égal, à dix pourcents près, à un premier nombre entier naturel, une étape de génération, par chaque pilier du premier ensemble, d'une deuxième composante fréquentielle dans le deuxième courant respectif, et une étape d'alimentation, avec chaque deuxième courant, d'un dispositif électrique correspondant par un conducteur de sortie respectif.

Suivant des modes de réalisation particuliers, le procédé de génération comprend une ou plusieurs des caractéristiques suivantes, prises isolément ou suivant toutes les combinaisons techniquement possibles :

- chaque pilier présente une première dimension dans une première direction et une deuxième dimension dans une deuxième direction perpendiculaire à la première direction, la première direction et la deuxième direction étant chacune perpendiculaire à la direction d'empilement, la première dimension et la deuxième dimension étant, chacune, comprise strictement entre 20 nanomètres et 5 micromètres.
- le premier matériau présente une première aimantation, le procédé comprenant, en outre, une étape de variation temporelle de la première aimantation de la couche libre d'au moins un pilier, avec la fréquence de résonance du pilier correspondant.
- la première composante fréquentielle présente une première amplitude, la deuxième composante fréquentielle présente une deuxième amplitude, et une fonction de transfert est définie pour chaque pilier comme étant le rapport, en valeur absolue, de la première amplitude et de la deuxième amplitude, la fonction de transfert étant une fonction au moins de la première fréquence et présentant une pluralité de maxima locaux, chaque maximum local correspondant à une troisième fréquence égale, à dix pourcents près, au rapport entre le double de la fréquence de résonance du pilier et un deuxième nombre entier naturel.
- la fréquence de résonance de chaque pilier du premier ensemble est identique à la fréquence de résonance de chaque autre pilier du premier ensemble, le premier nombre entier naturel étant, de préférence, égal à un.
- le distributeur de fréquence comporte, en outre, un deuxième ensemble de piliers, la fréquence de résonance de chaque pilier du deuxième ensemble étant identique à la fréquence de résonance de chaque autre pilier du deuxième ensemble, pour chaque pilier du deuxième ensemble, la différence entre la fréquence de résonance d'un pilier du deuxième ensemble et la fréquence de résonance d'un pilier du premier ensemble étant supérieure en valeur absolue à dix pourcents de la fréquence de résonance de chaque pilier du premier ensemble.
- le premier ensemble comporte au moins un premier pilier présentant une première fréquence de résonance et un deuxième pilier présentant une deuxième fréquence de résonance, le rapport entre le double de la première fréquence de résonance et la première fréquence étant égal, à dix pourcents près, à un troisième nombre entier naturel, et le rapport entre le double de la deuxième fréquence de résonance et la première fréquence étant égal, à dix pourcents près, à un quatrième nombre entier naturel différent du troisième nombre entier naturel.
- le premier matériau comprend au moins un élément choisi dans le groupe constitué de Co, Ni et Fe.
- l'organe de couplage comprend un conducteur électrique de couplage configuré pour être parcouru par le premier courant, le conducteur de couplage et au moins un pilier étant superposés selon la direction d'empilement.
- chaque pilier est cylindrique à base circulaire, chaque pilier présentant une génératrice parallèle à la direction d'empilement.

Des caractéristiques et avantages de l'invention apparaîtront à la lecture de la description qui va suivre, donnée uniquement à titre d'exemple non limitatif, et faite en référence aux dessins annexés, sur lesquels :

- la figure 1 est une représentation schématique d'un premier exemple de distributeur de fréquence comprenant une pluralité de piliers,
- la figure 2 est une vue en coupe d'un pilier de la figure 1, et
- la figure 3 est un ordinogramme d'un procédé de distribution de fréquence mis en œuvre par le distributeur de fréquence de la figure 1.

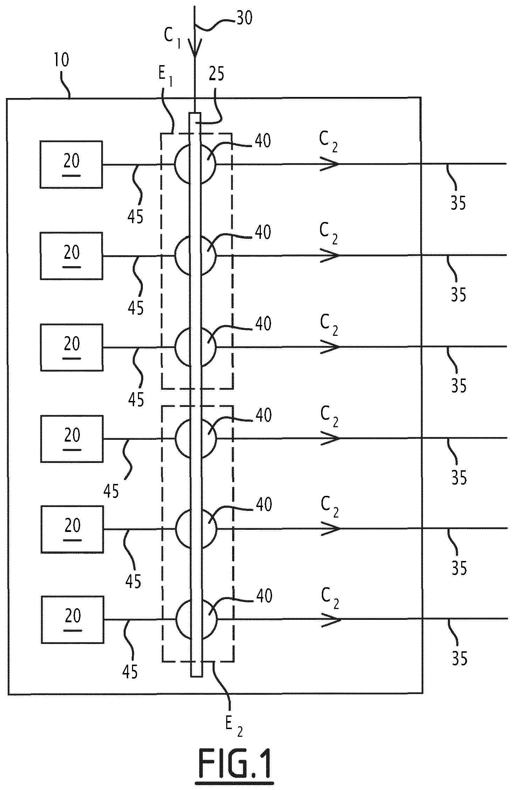

Un distributeur de fréquence 10 est représenté sur la figure 1.

Le distributeur de fréquence 10 est apte à recevoir en entrée un premier courant électrique C1, et à générer, à partir du premier courant électrique C1, une pluralité de deuxièmes courants C2.

Le distributeur de fréquence 10 comprend un substrat 15, au moins un organe de commande 20, un organe de couplage 25, un conducteur électrique d'entrée 30, une pluralité de conducteurs électriques de sortie 35, un premier ensemble E1 de piliers 40, un deuxième ensemble E2 de piliers 40 et une pluralité de conducteurs électriques de liaison 45.

Le substrat 15 présente une face supérieure Fs. La face supérieure Fs est plane.

Il est défini, pour le substrat 15, une direction d'empilement Z perpendiculaire à la face supérieure Fs du substrat 15.

Il est, en outre, défini pour le substrat 15 une première direction X et une deuxième direction Y. La première direction X est perpendiculaire à la direction d'empilement Z. La deuxième direction Y est perpendiculaire à la direction d'empilement Z. La deuxième direction Y est, en outre, perpendiculaire à la première direction X.

Chaque organe de commande 20 est configuré pour générer un deuxième courant électrique C2. Chaque organe de commande 20 est connecté électriquement à un pilier 40 par le conducteur électrique de liaison 45 correspondant.

En variante, l'organe de commande 20 est configuré pour générer une pluralité de deuxièmes courants électriques C2 et pour délivrer chaque deuxième courant électrique C2, à travers un conducteur électrique de liaison 45 respectif, à un pilier 40 correspondant. Le distributeur de fréquence 10 comprend alors un seul organe de commande 20.

L'organe de couplage 25 est connecté électriquement au conducteur électrique d'entrée 30.

L'organe de couplage 25 comprend un conducteur électrique de couplage 47.

Le conducteur électrique de couplage 47 est propre à permettre la circulation du premier courant C1.

De préférence, le conducteur électrique de couplage 47 est réalisé en forme d'une bande à section rectangulaire. Le conducteur électrique de couplage 47 présente au moins une face perpendiculaire à la direction d'empilement Z.

Le conducteur électrique de couplage 47 présente une largeur mesurée dans la première direction X et une hauteur mesurée selon la direction d'empilement Z.

La largeur du conducteur électrique de couplage 47 est comprise entre 1 $\mu$m et 30 $\mu$m. La hauteur du conducteur électrique de couplage 47 est comprise entre 100 nm et 500 nm.

Le conducteur électrique de couplage 47 est, par exemple, réalisé en or.

Le conducteur électrique de couplage 47 et au moins un pilier 40 sont superposés selon la direction d'empilement Z. De préférence, chaque pilier 40 sépare du substrat 15 au moins une portion du conducteur électrique de couplage 47.

Le conducteur d'entrée 30 est propre à recevoir le premier courant C1 et à transmettre le premier courant C1 à l'organe de couplage 25.

Chaque conducteur de sortie 35 est propre à recevoir d'un pilier 40 correspondant le deuxième courant électrique C2. Chaque conducteur de sortie 35 est propre à délivrer le deuxième courant électrique C2 à un dispositif électronique.

Par exemple, chaque conducteur de sortie 35 comprend un condensateur.

Chaque conducteur électrique de liaison 45 est propre à transmettre un deuxième courant C2 depuis l'organe de commande 20 jusqu'au pilier 40 correspondant.

Le conducteur de liaison 45 est délimité partiellement par le pilier 40 correspondant et par le substrat 15.

Chaque conducteur électrique de liaison 45 est, par exemple, réalisé en forme d'une bande à section rectangulaire. Chaque conducteur électrique de liaison 45 présente au moins une face perpendiculaire à la direction d'empilement Z.

Chaque conducteur électrique de liaison 45 est, par exemple, réalisé en or. En variante, chaque conducteur électrique de liaison 45 est réalisé en cuivre.

En complément facultatif, une couche d'accrochage permettant une meilleure tenue mécanique sépare chaque conducteur électrique de liaison 45 du pilier 40 correspondant.

Le premier ensemble E1 de piliers 40 comprend au moins un pilier 40.

De préférence, le premier ensemble E1 de piliers 40 comprend plusieurs piliers 40. Selon l'exemple de la figure 1, le premier ensemble E1 de piliers 40 comprend trois piliers 40.

Le deuxième ensemble E2 de piliers 40 comprend au moins un pilier 40.

De préférence, le deuxième ensemble E2 de piliers 40 comprend plusieurs piliers 40. Selon l'exemple de la figure 1, le deuxième ensemble E2 de piliers comprend trois piliers 40.

Le terme « pilier » est utilisé dans le domaine de la microélectronique ou de la nanoélectronique pour désigner une structure tridimensionnelle micrométrique ou nanométrique à sommet plat portée par le substrat 15. Il est entendu, pour une structure tridimensionnelle, par le terme « micrométrique » que la structure présente au moins une dimension inférieure ou égale à 100 micromètres ($\mu$m). Il est entendu, pour une structure tridimensionnelle, par le terme « nanométrique » que la structure présente au moins une dimension inférieure ou égale à 100 nanomètres (nm).

Chaque pilier 40 est délimité, selon la direction d'empilement Z, par une première face 50 et par une deuxième face 55. La deuxième face 55 est en contact avec la face supérieure Fs du substrat 15. Chaque pilier 40 est, en outre, délimité dans un plan perpendiculaire à la direction d'empilement Z par au moins une face latérale 60.

La première face 50 est plane. La première face 50 est perpendiculaire à la direction d'empilement Z.

La deuxième face 55 est plane. La deuxième face 55 est perpendiculaire à la direction d'empilement Z.

La face latérale 60 est perpendiculaire à la première face 50 et à la deuxième face 55.

Chaque pilier 40 présente une première dimension selon la première direction X, une deuxième dimension selon la deuxième direction Y et une hauteur selon la direction d'empilement Z.

La première dimension est comprise strictement entre 20 nm et 5 $\mu$m. La deuxième dimension est comprise strictement entre 20 nm et 5 $\mu$m.

La hauteur de chaque pilier est comprise entre 5 nm et 2 $\mu$m

Par exemple, chaque pilier 40 est cylindrique à base circulaire. Il est entendu par « cylindrique » que chaque pilier 40 est délimité par deux plans parallèles et par une surface délimitée par toutes les droites parallèles à une droite appelée génératrice du cylindre et coupant une courbe fermée appelée la courbe directrice du cylindre.

La courbe directrice de chaque pilier 40 est circulaire.

En complément facultatif, la génératrice de chaque pilier 40 est parallèle à la direction d'empilement Z.

Chaque pilier 40 présente un diamètre mesuré dans un plan perpendiculaire à la direction d'empilement Z. Le diamètre de chaque pilier 40 est compris entre 20 nm et 5 $\mu$m.

Chaque pilier 40 comporte un empilement 65 de couches superposées selon la direction d'empilement Z et une couche de passivation 70.

Chaque pilier 40 est configuré pour recevoir du conducteur de liaison 45 le deuxième courant C2 correspondant et pour délivrer le deuxième courant C2 au conducteur électrique de sortie 35 correspondant.

L'empilement 65 comprend une couche libre 75, une couche fixe 80 et une couche barrière 85.

La couche libre 75 est réalisée en un premier matériau magnétique M1.

Dans la suite de cette description, il est entendu par le terme « matériau magnétique », un matériau présentant une aimantation orientée selon une direction d'aimantation spécifique. Cela signifie que le matériau comprend une pluralité de moments magnétiques, et la résultante des moments magnétiques est un vecteur non nul. La direction d'aimantation est définie comme étant la direction de la résultante des moments magnétiques. Les moments magnétiques sont, par exemple, portés par des électrons présents dans le matériau.

En particulier, le terme « matériau magnétique » sera utilisé pour un matériau ferromagnétique ou un matériau ferrimagnétique.

Dans un matériau ferromagnétique, les moments magnétiques sont orientés parallèlement les uns aux autres. Lorsqu'un matériau ferromagnétique est soumis à un champ magnétique extérieur, les moments magnétiques du matériau s'orientent, en restant parallèles les uns aux autres, dans la direction du champ magnétique extérieur.

Dans un matériau ferrimagnétique, les moments magnétiques sont orientés antiparallèlement les uns aux autres, sans pour autant se compenser parfaitement.

La résultante des moments dans un matériau ferrimagnétique est strictement inférieure à la résultante des moments dans ce même matériau, si le matériau considéré était ferromagnétique. Lorsqu'un matériau ferrimagnétique est soumis à un champ magnétique extérieur, les moments magnétiques du matériau s'orientent, tout en restant antiparallèles les uns aux autres, de telle sorte que la résultante soit orientée dans la direction du champ magnétique extérieur.

Le premier matériau magnétique M1 est, par exemple, un matériau ferromagnétique.

Un grand nombre de matériaux ferromagnétiques comprennent du Cobalt (Co), du Fer (Fe), et/ou du Nickel (Ni). Par exemple, le premier matériau M1 est un alliage de plusieurs éléments, dont l'un au moins choisi dans le groupe constitué de Co, de Fe et de Ni.

De préférence, le premier matériau M1 est choisi dans le groupe constitué de Co, de Fe et de Ni, et de leurs alliages. Par exemple, le premier matériau M1 est le Permalloy, NiFe. En variante, le premier matériau M1 est un alliage de Co, de Fe, ou encore un alliage de Co, de Fe et de Bore.

La couche libre 75 présente une première aimantation A1.

La première aimantation A1 est variable. Cela signifie que la couche libre 75 est configurée pour que la première aimantation A1 varie au cours du temps.

Par exemple, la couche libre 75 est configurée pour que la première aimantation A1 soit modifiée par l'application d'un champ électromagnétique au pilier 40 considéré. Plus précisément, l'orientation de chaque moment magnétique de la couche libre 75 est susceptible de varier sous l'effet du champ électromagnétique.

La couche libre 75 est sensiblement planaire. Dans le cadre de cette description, il est entendu par « sensiblement planaire » que la couche considérée présente une largeur selon la première direction X, une longueur selon la deuxième direction Y, et une épaisseur selon la direction d'empilement Z, et que la longueur et la largeur de la couche considérée sont chacune supérieure ou égale à dix fois l'épaisseur de la couche considérée.

La couche libre 75 présente une première épaisseur e1. La première épaisseur e1 est, par exemple, comprise entre 1 nm et 30 nm.

La couche libre 75 est délimitée au moins partiellement, selon la direction d'empilement Z, par la couche de passivation 70 et par la couche barrière 85.

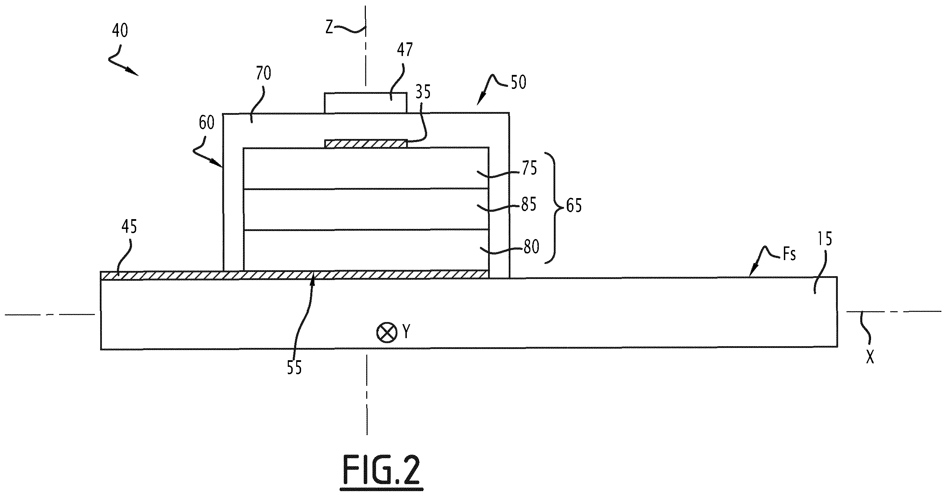

Selon l'exemple de la figure 2, la couche libre 75 est en contact électrique avec le conducteur électrique de sortie 35. Le conducteur électrique de sortie 35 est, par exemple, partiellement reçu entre la couche libre 75 et la couche de passivation 70.

La couche fixe 80 présente une deuxième aimantation A2. La deuxième aimantation A2 est fixe. Cela signifie que l'orientation de la deuxième aimantation A2 est invariante au cours du temps.

La couche fixe 80 est réalisée au moins partiellement en un deuxième matériau magnétique M2. Par exemple, la couche fixe comprend deux couches d'un matériau ferromagnétique séparées l'une de l'autre par une couche de ruthénium.

La couche fixe 80 est sensiblement planaire.

La couche fixe 80 présente une deuxième épaisseur e2. La deuxième épaisseur e2 est, par exemple, comprise entre 1 nm et 30 nm.

La couche fixe 80 est délimitée, selon la direction d'empilement Z, par la couche barrière 85 et par le conducteur de liaison 45.

La couche barrière 85 est sensiblement planaire.

Selon la direction d'empilement Z, la couche barrière 85 sépare la couche fixe 80 et la couche libre 75.

La couche barrière 85 est réalisée en un matériau non magnétique.

De préférence, la couche barrière 85 est réalisée en un matériau non magnétique et électriquement isolant.

La couche barrière 85 est, par exemple, réalisée en oxyde de magnésium (MgO).

La couche barrière 85 est propre à être traversée par le deuxième courant C2 par effet tunnel.

La couche barrière 85 présente une troisième épaisseur e3. La troisième épaisseur e3 est comprise, par exemple, entre 0,5 nm et 5 nm.

La couche de passivation 70 est adaptée pour isoler électriquement et chimiquement l'empilement 65 de l'extérieur de la couche de passivation 70. Par exemple, la couche de passivation 70 est une couche conforme recouvrant l'empilement 65. Une couche conforme est une couche présentant une épaisseur uniforme, et dont la forme reproduit la forme d'une structure recouverte par la couche conforme.

La couche de passivation 70 est réalisée en un quatrième matériau M4. Le quatrième matériau M4 est un oxyde. De préférence, le quatrième matériau M4 est l'oxyde de silicium $SiO_2$. L'oxyde de silicium $SiO_2$ est un matériau isolant fréquemment utilisé dans le domaine de la microélectronique.

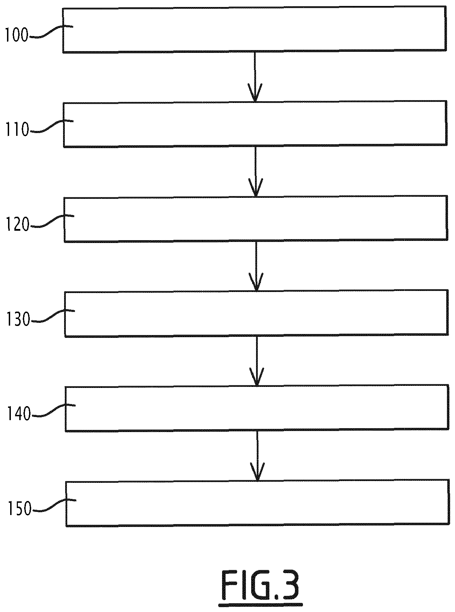

Un ordinogramme d'un premier exemple de procédé de génération d'une pluralité de deuxième courants C2 est représenté sur la figure 3.

Le procédé comprend une étape 100 de fourniture d'un distributeur de fréquence 10 tel que décrit ci-dessus, une étape 110 de génération d'une pluralité de deuxièmes courants C2, une étape 120 de variation temporelle de la première aimantation A1, une étape 130 d'excitation, une étape 140 de génération d'une deuxième composante fréquentielle c2 et une étape 150 d'alimentation d'un dispositif électronique.

Lors de l'étape 100 de fourniture, un distributeur de fréquence 10 est fourni. Par exemple, lors de l'étape 100 de fourniture, le distributeur de fréquence 10 est fabriqué en utilisant des techniques de dépôt de couches minces et des techniques de gravure. De préférence, le distributeur de fréquence 10 est intégré dans une installation électronique comprenant une pluralité de dispositifs électroniques que le distributeur de fréquence 10 est propre à alimenter chacun avec un deuxième courant C2 correspondant.

Lors de l'étape 100 de fourniture, le premier courant C1 est, en outre, transmis au conducteur d'entrée 30.

Le premier courant C1 présente une première tension U1 et une première intensité I1. Le premier courant C1 présente une première composante fréquentielle c1.

Il est entendu, pour un courant électrique, par le terme « présentant un ensemble de composantes fréquentielles » qu'il existe au moins une décomposition du courant dans laquelle le courant est la somme de plusieurs courants dont au moins un est un courant sinusoïdal. Chaque composante fréquentielle présente une tension et une intensité, qui sont chacune calculées mathématiquement par une transformée de Fourier de la tension ou de l'intensité du courant.

La première composante fréquentielle c1 est une composante radiofréquence présentant une première fréquence f1 comprise entre 3 MHz et 100 GHz.

La première composante fréquentielle c1 présente une première amplitude a1.

Dans la suite de cette description, l'amplitude d'une grandeur variable, telle qu'une tension ou une intensité d'une composante fréquentielle, est définie comme étant la différence entre la valeur maximale et la valeur minimale de la grandeur, en valeur absolue.

Lors de l'étape 110 de génération, au moins un deuxième courant C2 est généré par l'organe de commande 20 correspondant.

Chaque deuxième courant C2 présente une deuxième intensité I2. Chaque deuxième courant C2 est transmis, par le conducteur de liaison 45 correspondant, à un pilier 40 respectif.

Chaque deuxième courant C2 est un courant continu. Par exemple, l'organe de commande 20 impose une valeur constante de la deuxième intensité I2.

Chaque deuxième courant C2 traverse le pilier 40 correspondant selon la direction d'empilement Z. Chaque pilier 40 du premier ensemble E1 et chaque pilier 40 du deuxième ensemble E2 sont donc traversés par un deuxième courant C2 correspondant.

Une résistance électrique R est définie pour chaque pilier 40 comme étant la résistance électrique perçue par le deuxième courant C2 correspondant lorsque le deuxième courant C2 traverse le pilier 40.

Lors de l'étape 120 de variation, la première aimantation A1 de la couche libre 75 de chaque pilier 40 du premier ensemble E1 et du deuxième ensemble E2 est modifiée au cours du temps.

Plus précisément, les moments magnétiques présents dans la couche libre 75 sont mis en mouvement, au point de résulter en une variation temporelle de la première aimantation A1. Par exemple, l'amplitude de la première aimantation A1 varie périodiquement dans le temps. De préférence, l'orientation de la première aimantation A1 varie périodiquement dans le temps.

En pratique, la variation temporelle périodique est obtenue par la création, dans la couche libre 75, d'une configuration magnétique dans laquelle l'orientation des moments magnétiques est, à un instant donné, non uniforme. Par exemple, la variation temporelle périodique est un ensemble d'au moins une onde de spin.

La configuration magnétique de la couche libre 75 est obtenue grâce au deuxième courant C2.

Par effet de « couplage de transfert de spin », une onde de spin SW est générée dans la couche libre 75.

Par exemple, les moments magnétiques subissent chacun un mouvement de précession autour d'une direction moyenne. Le mouvement de précession se traduit par une variation locale de la direction de la première aimantation A1 du premier matériau magnétique M1. La déviation locale de l'aimantation est susceptible de se propager dans le premier matériau magnétique M1 sous la forme d'une onde appelée « onde de spin » SW.

L'onde de spin SW est, par exemple, une onde stationnaire. Une onde stationnaire est le phénomène résultant de la propagation simultanée dans des directions différentes de plusieurs ondes de même fréquence, dans le même milieu physique, qui forme une figure dont certains éléments sont fixes dans le temps. Au lieu d'y voir une onde qui se propage, on constate une vibration stationnaire mais d'intensité différente, en chaque point observé.

En variante, la couche libre 75 présente une configuration en vortex de la première aimantation A1 dans laquelle les moments magnétiques sont orientés perpendiculairement à la direction d'empilement Z et s'enroulent autour du centre de la couche libre 75, sauf dans une région centrale de la couche libre 75. Dans la région centrale, les moments magnétiques ne sont pas perpendiculaires à la direction d'empilement Z.

La variation de la première aimantation A1 présente une fréquence de résonance $f0$. La fréquence de résonance $f0$ est une fréquence caractéristique de la configuration des moments magnétiques dans la couche libre 75. Par exemple, la fréquence de résonance $f0$ est la fréquence de l'onde de spin.

La fréquence de résonance $f0$ dépend, entre autres, de la nature du premier matériau M1, du diamètre du pilier $f0$, et de l'épaisseur de la couche libre 75.

La fréquence de résonance $f0$ de chaque pilier 40 du premier ensemble E1 est égale à la fréquence de résonance $f0$ de chaque autre pilier 40 du premier ensemble E1. Par exemple, la fréquence de résonance $f0$ de chaque pilier 40 du premier ensemble E1 est égale à 1 GHz.

La fréquence de résonance $f0$ de chaque pilier 40 du deuxième ensemble E2 est égale à la fréquence de résonance $f0$ de chaque autre pilier 40 du deuxième ensemble E2.

De préférence, la fréquence de résonance $f0$ de chaque pilier du deuxième ensemble E2 est située hors d'un intervalle de fréquences centré sur la fréquence de résonance $f0$ de chaque pilier 40 du premier ensemble E1 et large de vingt pourcents de la fréquence de résonance de chaque pilier 40 du premier ensemble E1. Par exemple, la fréquence de résonance $f0$ de chaque pilier 40 du deuxième ensemble E2 est égale à cinq quarts de la fréquence de résonance $f0$.

La couche libre 75, la couche fixe 80 et la couche barrière 85 forment une jonction tunnel magnétique. Cela signifie que la résistance R de chaque pilier 40 est susceptible d'être modifiée par une modification de l'aimantation de la couche libre 75 et/ou une modification de l'aimantation de la couche fixe 80.

Selon l'effet de « magnétorésistance tunnel », la résistance électrique R de chaque pilier 40 dépend de l'angle entre la première aimantation A1 et la deuxième aimantation A2. La deuxième aimantation A2 étant fixe, la résistance électrique R dépend donc de l'orientation des moments magnétiques de la couche libre 75 du pilier 40 considéré.

Lorsque le deuxième courant C2 traverse une couche libre 75 dont la première aimantation A1 varie périodiquement, en l'absence de champ électro-magnétique, par effet de « magnétorésistance tunnel », la résistance R du pilier 40 considéré varie au cours du temps avec la fréquence de résonance $f0$ du pilier 40 considéré.

Lors de l'étape 120 de création, chaque pilier 40 génère alors dans le deuxième courant C2 correspondant, une troisième composante fréquentielle $c3$. La troisième composante fréquentielle $c3$ présente la fréquence de résonance $f0$ du pilier 40. Le deuxième courant C2 n'est alors plus un courant continu mais un courant périodique.

Lors de l'étape 130 d'excitation, le premier courant C1 est reçu par le conducteur électrique d'entrée 30. Le premier courant C1 est transmis par le conducteur électrique d'entrée 30 à l'organe de couplage 25. De préférence, le conducteur électrique d'entrée 30 transmet le premier courant C1 au conducteur électrique de couplage 47.

Le conducteur électrique de couplage 47 est traversé par le premier courant C1. Le conducteur électrique de couplage 47 génère alors un champ électromagnétique EM. Comme le premier courant C1 présente la première composante fréquentielle $c1$, le champ électromagnétique EM présente la première fréquence $f1$.

Le champ électromagnétique EM présente une longueur d'onde A définie comme étant le rapport entre la célérité c de la lumière dans le vide et la première fréquence $f1$.

Par exemple, l'organe de couplage 25 est distant de chaque pilier 40 d'une distance maximale inférieure à la longueur d'onde A. La distance maximale est définie comme étant la distance entre le point de l'organe de couplage le plus proche du pilier 40 et le point du pilier 40 le plus éloigné de l'organe de couplage.

Le conducteur électrique de couplage 47 excite au moins une portion de chaque pilier 40 avec le champ électromagnétique EM. Par exemple, le conducteur électrique de couplage 47 excite la couche libre 75 avec le champ électromagnétique EM.

Il est entendu par le terme « exciter » que, lorsqu'un pilier 40, est traversé par le deuxième courant électrique C2 correspondant, au moins une grandeur du deuxième courant électrique C2 est modifiée lorsque le pilier 40 est soumis au champ électromagnétique EM par rapport à la même grandeur lorsque le pilier 40 n'est pas soumis au champ électromagnétique EM. Par exemple, lorsque le pilier 40 est soumis au champ électromagnétique EM, une intensité du deuxième courant C2 et/ou une tension du deuxième courant C2 sont modifiées.

La première composante fréquentielle $c1$ présente une première fréquence $f1$ égale, à 10 % près, au rapport entre le double de la fréquence de résonance f0 de chaque pilier 40 du premier ensemble E1 et un premier nombre entier naturel n1. Cela s'écrit mathématiquement :

$$f1 = \frac{2f_0}{n1} \pm 0,1 * \frac{2f_0}{n1} \qquad \text{(Equation 1)}$$

De préférence, le premier nombre entier naturel n1 est égal à un. Dans ce cas, la première fréquence f1 est égale à deux fois la fréquence de résonance f0 de chaque pilier 40 du premier ensemble E1.

Lors de l'étape 140 de génération d'une deuxième composante fréquentielle, une deuxième composante fréquentielle c2 est générée par chaque pilier 40 du premier ensemble E1, par effet paramétrique et par résonance, dans le deuxième courant C2 correspondant.

Chaque deuxième composante fréquentielle c2 est une composante radiofréquence présentant une deuxième fréquence f2 comprise entre 3 MHz et 100 GHz.

Chaque deuxième composante fréquentielle c2 présente une deuxième amplitude a2.

Chaque deuxième composante fréquentielle c2 présente une deuxième fréquence f2 égale à la fréquence de résonance f0 du pilier 40 correspondant.

L'existence, dans le deuxième courant C2, de la deuxième composante fréquentielle c2, fait que le deuxième courant C2 est alors un courant périodique et non plus un courant continu.

L'effet paramétrique mélangé avec la résonance classique résulte, lors de l'excitation d'un système présentant une fréquence de résonance, en l'apparition d'une réponse du système à la fréquence de résonance lorsque l'excitation est effectuée avec une fréquence proche d'un multiple de la demie fréquence de résonance du système.

Ici, via l'excitation de chaque pilier 40 du premier ensemble E1 par le champ électromagnétique EM présentant une première fréquence f1 égale, à 10 % près, au double de la fréquence de résonance f0 de chaque pilier 40 considéré, une deuxième composante fréquentielle c2 présentant la fréquence de résonance f0 de chaque pilier 40 du premier ensemble E1 est générée dans chaque deuxième courant C2 correspondant.

La première aimantation A1 de la couche libre 75 de chaque pilier 40 est modifiée par le champ électromagnétique EM. Le champ électromagnétique EM exerce sur chaque moment magnétique de la couche libre 75 un couple de rotation qui modifie l'orientation de chaque moment magnétique. La direction de l'aimantation A1 est alors modifiée.

Par effet de « magnétorésistance tunnel », la résistance électrique R de chaque pilier 40 est modifiée par le champ électromagnétique EM. Comme le champ électromagnétique EM présente la première fréquence f1, qui est multiple de la fréquence de résonance f0 de chaque pilier 40 du premier ensemble E1, par effet paramétrique la résistance électrique R de chaque pilier 40 du premier ensemble E1 varie avec la fréquence de résonance f0 considérée.

La deuxième fréquence f2 de la deuxième composante fréquentielle c2 générée par chaque pilier 40 du premier ensemble E1 est donc égale à la fréquence de résonance f0 de chaque pilier 40 du premier ensemble E1.

Une fonction de transfert F est définie pour chaque pilier 40 comme étant le rapport, en valeur absolue, entre la première amplitude a1 et la deuxième amplitude a2 de la deuxième composante fréquentielle C2 correspondante. La fonction de transfert F est une fonction au moins de la première fréquence f1.

Par effet paramétrique, la fonction de transfert F de chaque pilier 40 présente une pluralité de maxima locaux correspondant chacun à une troisième fréquence f3 respective.

Chaque troisième fréquence f3 est égale, à dix pourcents (%) près, au rapport entre le double de la fréquence de résonance f0 du pilier 40 considéré et un deuxième nombre entier naturel n2. Cela s'écrit mathématiquement :

$$f_3 = \frac{2f_0}{n2} \pm 0,1 * \frac{2f_0}{n2} \qquad \text{(Equation 2)}$$

La fonction de transfert F est une fonction continue. Chaque maximum présente donc une largeur non-nulle. Chaque maximum présente une largeur à mi-hauteur inférieure ou égale à 1 % de la troisième fréquence f3. Par exemple, la largeur à mi-hauteur est inférieure ou égale à 0,1% de la troisième fréquence f3. La largeur à mi-hauteur est un paramètre défini pour de nombreuses fonctions susceptibles de représenter un tel pic, telles que la fonction Lorentzienne.

De préférence, chaque largeur à mi-hauteur est inférieure ou égale à 1 mégaHertz (MHz).

Grâce à l'effet paramétrique, la deuxième amplitude a2 présente une valeur très supérieure à la valeur que la deuxième amplitude a2 présenterait si la première fréquence n'était pas égale, à 10% près, à une troisième fréquence f3 du pilier 40 considéré.

Comme la première fréquence f1 n'est pas égale, à 10% près, à une troisième fréquence f3 des piliers 40 du deuxième ensemble E2, aucune deuxième composante fréquentielle c2 n'est générée par les piliers 40 du deuxième ensemble E2.

Lors de l'étape 150 d'alimentation, chaque deuxième courant C2 est délivré par le pilier 40 correspondant, à travers le conducteur électrique de sortie 35 correspondant, à un dispositif électronique respectif.

L'amplitude de chaque deuxième composante fréquentielle c2 générée dépend de l'intensité I2 du deuxième courant C2 correspondant. Le procédé permet donc un meilleur contrôle de la puissance du signal avec lequel chaque dispositif électronique est alimenté, via le choix de l'intensité I2 du deuxième courant C2.

De plus, le distributeur de fréquence 10 est de plus petite taille que les diviseurs de puissance de l'état de la technique. En outre, dans l'exemple de fonctionnement ci-dessus, la première fréquence f1 est égale à une troisième fréquence f3 des piliers 40 du premier ensemble E1, qui génèrent donc chacune une deuxième composante fréquentielle c2. Cependant, si la première fréquence f1 avait été égale à une troisième fréquence f3 des piliers 40 du deuxième ensemble E2, une deuxième composante fréquentielle c2 aurait été générée par chacune des piliers 40 du deuxième ensemble E2, et transmise au conducteur électrique de sortie 35 correspondant.

Le procédé permet de contrôler aisément la répartition des signaux générés à différents dispositifs en fonction de la première fréquence f1.

De plus, seules les composantes fréquentielles du premier courant C1 dont la fréquence est égale, à 10% près, à une troisième fréquence f3 d'un pilier 40 traversé par un deuxième courant C2 donnent lieu à la génération, dans un deuxième courant C2, d'une deuxième composante fréquentielle c2.

Le procédé permet donc également un filtrage du signal transmis aux dispositifs.

Dans un deuxième exemple de procédé de génération de deuxièmes courants C2, au cours de l'étape 120 de génération d'un deuxième courant C2, certains deuxièmes courants C2 ne sont pas générés.

Le procédé permet alors d'alimenter sélectivement une partie seulement des dispositifs avec la deuxième composante fréquentielle c2.

Dans un troisième exemple de distributeur de fréquence 10, le premier ensemble E1 comprend au moins un premier pilier 40 et un deuxième pilier 40.

Les éléments identiques au premier exemple de distributeur de fréquence de la figure 1 ne sont pas décrits à nouveau. Seules les différences sont mises en évidence.

Le premier pilier 40 présente une première fréquence de résonance f0. Le deuxième pilier 40 présente une deuxième fréquence de résonance f0.

Le rapport entre le double de la première fréquence de résonance f0 et la première fréquence f1 est égal, à 10% près, à un troisième entier naturel n3. Le rapport entre le double de la deuxième fréquence de résonance f0 et la première fréquence f1 est égal, à 10% près, à un quatrième entier naturel n4.

Le fonctionnement du troisième exemple de distributeur de fréquence 10 est identique au fonctionnement du premier exemple de distributeur de fréquence 10 de la figure 1.

Lors de l'étape 140 de génération d'une deuxième composante fréquentielle c2, le premier pilier 40 et le deuxième pilier 40 génèrent chacun une deuxième composante fréquentielle c2 dans le deuxième courant C2 correspondant.

La deuxième composante fréquentielle c2 générée par le premier pilier 40 présente la première fréquence de résonance f0.

La deuxième composante fréquentielle c2 générée par le deuxième pilier 40 présente la deuxième fréquence de résonance f0.

Le procédé permet alors d'alimenter, à partir d'un même premier courant C1, différents dispositifs électroniques avec des deuxièmes courants C2 présentant des deuxièmes fréquences f2 différentes.

## Revendications

1. Procédé de génération, à partir d'un premier courant électrique (C1) comportant au moins une première composante fréquentielle (c1) présentant une première fréquence (f1), d'une pluralité de deuxièmes courants (C2) présentant chacun une deuxième composante fréquentielle (c2) respective, le procédé comprenant les étapes de :

   - fourniture (100) d'un distributeur de fréquence (10) comportant :

      • un premier ensemble (E1) de piliers (40), chaque pilier (40) comprenant un empilement (65) de couches superposées selon une direction d'empilement (Z), l'empilement (65) comprenant au moins :

         ◦ une couche libre (75) réalisée en un premier matériau magnétique (M1),
         ◦ une couche fixe (80) réalisée en un deuxième matériau magnétique (M2), et
         ◦ une couche barrière (85) réalisée en un troisième matériau (M3) non-magnétique, la couche barrière (85) séparant la couche libre (75) de la couche fixe (80) selon la direction d'empilement (Z),

• au moins un organe (20) de commande propre à générer un deuxième courant électrique (C2),
• un organe de couplage (25), et
• une pluralité de conducteurs électriques de sortie (35), chaque conducteur électrique de sortie (35) étant propre à alimenter un dispositif électrique avec un deuxième courant électrique (C2) respectif, chaque pilier (40) étant propre, lorsque le pilier (40) est traversé par un courant continu et n'est pas excité par l'organe de couplage (25), à générer dans le courant continu une troisième composante fréquentielle (c3) présentant une fréquence appelée fréquence de résonance (f0) dudit pilier (40),

- génération (110) d'une pluralité de deuxièmes courants électriques (C2), chaque pilier (40) du premier ensemble (E1) étant traversé par un deuxième courant (C2) respectif selon la direction d'empilement (Z),
- excitation (130), par l'organe de couplage (25), de chaque pilier (40) du premier ensemble (E1) avec un champ électromagnétique (EM) présentant la première fréquence (f1), le rapport entre le double de la fréquence de résonance (f0) de chaque pilier (40) du premier ensemble (E1) et la première fréquence (f1) étant égal, à dix pourcents près, à un premier nombre entier naturel (n1),
- génération (140), par chaque pilier (40) du premier ensemble (E1), d'une deuxième composante fréquentielle (c2) dans le deuxième courant (C2) respectif, et
- alimentation (150), avec chaque deuxième courant (C2), d'un dispositif électrique correspondant par un conducteur de sortie (35) respectif.

2. Procédé selon la revendication 1, dans lequel chaque pilier (40) présente une première dimension dans une première direction (X) et une deuxième dimension dans une deuxième direction (Y) perpendiculaire à la première direction (X), la première direction (X) et la deuxième direction (Y) étant chacune perpendiculaire à la direction d'empilement (Z),
la première dimension et la deuxième dimension étant, chacune, comprise strictement entre 20 nanomètres et 5 micromètres.

3. Procédé selon la revendication 1 ou 2, dans lequel le premier matériau (M1) présente une première aimantation (A1), le procédé comprenant, en outre, une étape (120) de variation temporelle de la première aimantation (A1) de la couche libre (75) d'au moins un pilier (40), avec la fréquence de résonance (f0) du pilier (40) correspondant.

4. Procédé selon l'une quelconque des revendications 1 à 3, dans lequel la première composante fréquentielle (c1) présente une première amplitude (a1), la deuxième composante fréquentielle (c2) présente une deuxième amplitude (a2), et une fonction de transfert (F) est définie pour chaque pilier (40) comme étant le rapport, en valeur absolue, de la première amplitude (a1) et de la deuxième amplitude (a2), la fonction de transfert (F) étant une fonction au moins de la première fréquence (f1) et présentant une pluralité de maxima locaux, chaque maximum local correspondant à une troisième fréquence (f3) égale, à dix pourcents près, au rapport entre le double de la fréquence de résonance (f0) du pilier et un deuxième nombre entier naturel (n2).

5. Procédé selon l'une quelconque des revendications 1 à 4, dans lequel la fréquence de résonance (f0) de chaque pilier (40) du premier ensemble (E1) est identique à la fréquence de résonance (f0) de chaque autre pilier (40) du premier ensemble (E1), le premier nombre entier naturel (n1) étant, de préférence, égal à un.

6. Procédé selon la revendication 5, dans lequel le distributeur de fréquence comporte (10), en outre, un deuxième ensemble (E2) de piliers, la fréquence de résonance (f0) de chaque pilier (40) du deuxième ensemble (E2) étant identique à la fréquence de résonance (f0) de chaque autre pilier (40) du deuxième ensemble (E2), pour chaque pilier (40) du deuxième ensemble (E2), la différence entre la fréquence de résonance (f0) d'un pilier (40) du deuxième ensemble (E2) et la fréquence de résonance (f0) d'un pilier du premier ensemble (E1) étant supérieure en valeur absolue à dix pourcents de la fréquence de résonance (f0) de chaque pilier (40) du premier ensemble (E1).

7. Procédé selon l'une quelconque des revendications 1 à 4, dans lequel le premier ensemble (E1) comporte au moins un premier pilier (40) présentant une première fréquence de résonance (f0) et un deuxième pilier (40) présentant une deuxième fréquence de résonance (f0),
le rapport entre le double de la première fréquence de résonance (f0) et la première fréquence (f1) étant égal, à dix pourcents près, à un troisième nombre entier naturel (n3), et
le rapport entre le double de la deuxième fréquence de résonance (f0) et la première fréquence (f1) étant égal, à dix pourcents près, à un quatrième nombre entier naturel (n4) différent du troisième nombre entier naturel (n3).

8. Procédé selon l'une quelconque des revendications 1 à 7, dans lequel le premier matériau (M1) comprend au moins un élément choisi dans le groupe constitué de Co, Ni et Fe.

9. Procédé selon l'une quelconque des revendications 1 à 8, dans lequel l'organe de couplage (25) comprend un conducteur électrique (47) de couplage configuré pour être parcouru par le premier courant (C1), le conducteur de couplage (47) et au moins un pilier (40) étant superposés selon la direction d'empilement (Z).

10. Procédé selon l'une quelconque des revendications 1 à 9, dans lequel chaque pilier (40) est cylindrique à base circulaire, chaque pilier (40) présentant une génératrice parallèle à la direction d'empilement (Z).

**Patentansprüche**

1. Verfahren zum Erzeugen einer Mehrzahl von zweiten Strömen (C2), die jeweils eine zweite jeweilige Frequenzkomponente (c2) aufweisen, aus einem ersten elektrischen Strom (C1), der mindestens eine erste Frequenzkomponente (c1) aufweist, die eine erste Frequenz (f1) aufweist, wobei das Verfahren die Schritte umfasst:

- Bereitstellen (100) einer Frequenzverteilungsvorrichtung (10), aufweisend:

• eine erste Anordnung (E1) von Säulen (40), wobei jede Säule (40) einen Stapel (65) aus gemäß einer Stapelrichtung (Z) übereinander liegenden Schichten umfasst, wobei der Stapel (65) mindestens umfasst:

○ eine freie Schicht (75), die aus einem ersten magnetischen Material (M1) hergestellt ist,
○ eine feste Schicht (80), die aus einem zweiten magnetischen Material (M2) hergestellt ist, und
○ eine Sperrschicht (85), die aus einem dritten nicht magnetischen Material (M3) hergestellt ist, wobei die Sperrschicht (85) in der Stapelrichtung (Z) die freie Schicht (75) von der festen Schicht (80) trennt,

• mindestens ein Steuerelement (20), das geeignet ist, einen zweiten elektrischen Strom (C2) zu erzeugen,
• ein Koppelelement (25) und
• eine Mehrzahl von elektrischen Ausgangsleitern (35), wobei jeder elektrische Ausgangsleiter (35) geeignet ist, eine elektrische Vorrichtung mit einem jeweiligen zweiten elektrischen Strom (C2) zu versorgen, jede Säule (40) geeignet ist, wenn die Säule (40) von einem Gleichstrom durchströmt wird und nicht von dem Koppelelement (25) erregt wird, in dem Gleichstrom eine dritte Frequenzkomponente (c3) zu erzeugen, die eine Frequenz, genannt Resonanzfrequenz (f0) der Säule (40) aufweist,

- Erzeugen (110) einer Mehrzahl von zweiten elektrischen Strömen (C2), wobei jede Säule (40) der ersten Anordnung (E1) von jeweils einem zweiten Strom (C2) in der Stapelrichtung (Z) durchströmt wird,
- Erregen (130) jede der Säulen (40) der ersten Anordnung (E1) mit einem die erste Frequenz (f1) aufweisenden elektromagnetischen Feld (EM) durch das Koppelelement (25), wobei das Verhältnis zwischen dem Doppelten der Resonanzfrequenz (f0) jeder Säule (40) der ersten Anordnung (E1) und der ersten Frequenz (f1) mit 10 % Genauigkeit gleich einer ersten natürlichen ganzen Zahl (n1) ist,
- Erzeugen (140) einer zweiten Frequenzkomponente (c2) in dem jeweiligen zweiten Strom (C2) durch jede Säule (40) der ersten Anordnung (E1) und
- Versorgen (150) einer entsprechenden elektrischen Vorrichtung durch einen jeweiligen Ausgangsleiter (35) mit jedem zweiten Strom (C2).

2. Verfahren nach Anspruch 1, bei dem jede Säule (40) eine erste Dimension in einer ersten Richtung (X) und eine zweite Dimension in einer zweiten Richtung (Y), senkrecht zur ersten Richtung (X) aufweist, wobei die erste Richtung (X) und die zweite Richtung (Y) jeweils senkrecht zur Stapelrichtung (Z) sind.

3. Verfahren nach Anspruch 1 oder 2, bei dem das erste Material (M1) eine erste Magnetisierung (A1) aufweist, wobei das Verfahren außerdem einen Schritt (120) des zeitlichen Veränderns der ersten Magnetisierung (A1) der freien Schicht (75) mindestens einer Säule (40) mit der Resonanzfrequenz (f0) der entsprechenden Säule (40) umfasst.

4. Verfahren nach einem beliebigen der Ansprüche 1 bis 3, bei dem die erste Frequenzkomponente (c1) eine erste Amplitude (a1) aufweist, die zweite Frequenzkomponente (c2) eine zweite Amplitude (a2) aufweist und eine Übertragungsfunktion (F) für jede Säule (40) als das Verhältnis der ersten Amplitude (a1) zu der zweiten Amplitude (a2) als Absolutwert definiert wird, wobei die Übertragungsfunktion (F) eine Funktion mindestens der ersten Frequenz (f1) ist und eine Mehrzahl von lokalen Maxima aufweist, wobei jedes lokale Maximum einer dritten Frequenz (f3) gleich dem Verhältnis zwischen dem Doppelten der Resonanzfrequenz (f0) der Säule und einer zweiten natürlichen ganzen Zahl (n2) mit einer Genauigkeit von 10 % entspricht.

5. Verfahren nach einem beliebigen der Ansprüche 1 bis 4, bei dem die Resonanzfrequenz (f0) jeder Säule (40) der ersten Anordnung (E1) identisch zu der Resonanzfrequenz (f0) jeder anderen Säule (40) der ersten Anordnung (E1) ist, wobei die erste natürliche ganze Zahl (n1) vorzugsweise gleich 1 ist.

6. Verfahren nach Anspruch 5, bei der die Frequenzverteilungsvorrichtung (10) außerdem eine zweite Anordnung (E2) von Säulen aufweist, wobei die Resonanzfrequenz (f0) jeder Säule (40) der zweiten Anordnung (E2) identisch zu der Resonanzfrequenz (f0) jeder anderen Säule (40) der zweiten Anordnung (E2) für jede Säule (40) der zweiten Anordnung (E2) ist, wobei die Differenz zwischen der Resonanzfrequenz (f0) einer Säule (40) der zweiten Anordnung (E2) und der Resonanzfrequenz (f0) einer Säule der ersten Anordnung (E1) im Absolutwert größer ist als 10 % der Resonanzfrequenz (f0) jeder Säule (40) der ersten Anordnung (E1).

7. Verfahren nach einem beliebigen der Ansprüche 1 bis 4, bei dem die erste Anordnung (E1) mindestens eine erste Säule (40), die eine erste Resonanzfrequenz (f0) hat, und eine zweite Säule (40) aufweist, die eine zweite Resonanzfrequenz (f0) hat,

wobei das Verhältnis zwischen dem Doppelten der ersten Resonanzfrequenz (f0) und der ersten Frequenz (f1) mit 10 % Genauigkeit gleich einer dritten natürlichen ganzen Zahl (n3) ist und das Verhältnis zwischen dem Doppelten der zweiten Resonanzfrequenz (f0) und der ersten Frequenz (f1) mit 10 % Genauigkeit gleich einer vierten natürlichen ganzen Zahl (n4), unterschiedlich zur dritten natürlichen ganzen Zahl (n3), ist.

8. Verfahren nach einem beliebigen der Ansprüche 1 bis 7, bei dem das erste Material (M1) mindestens ein Element umfasst, das aus der Gruppe, bestehend aus Co, Ni und Fe ausgewählt ist.

9. Verfahren nach einem beliebigen der Ansprüche 1 bis 8, bei dem das Koppelelement (25) einen elektrischen Koppelleiter (47) umfasst, der ausgebildet ist, von dem ersten Strom (C1) durchströmt zu werden, wobei der Koppelleiter (47) und mindestens eine Säule (40) gemäß der Stapelrichtung (Z) übereinanderliegen.

10. Verfahren nach einem beliebigen der Ansprüche 1 bis 9, bei dem jede Säule (40) zylindrisch mit kreisförmiger Grundfläche ist und jede Säule (40) eine Mantellinie parallel zu der Stapelrichtung (Z) aufweist.

**Claims**

1. A method for generating, from a first electric current (C1) including at least a first frequency component (c1) having a first frequency (f1), a plurality of second currents (C2) each having a second respective frequency component (c2), the method comprising the following steps:

- supplying (100) a frequency distributor (10) including:

• a first set (E1) of pillars (40), each pillar (40) comprising a stack (65) of layers superimposed in a stacking direction (Z), the stack (65) comprising at least:

  ◦ a free layer (75) made from a first magnetic material (M1),
  ◦ a fixed layer (80) made from a second magnetic material (M2), and
  ◦ a barrier layer (85) made from a third nonmagnetic material (M3), the barrier layer (85) separating the free layer (75) from the fixed layer (80) in the stacking direction (Z),

• at least one control member (20) able to generate a second electric current (C2),
• a coupling member (25), and
• a plurality of electrical output conductors (35), each electrical output conductor (35) being able to supply an electrical device with a respective second electric current (C2),
each pillar (40) being able, when the pillar (40) is passed through by a direct current and is not excited by the coupling member (25), to generate, in the direct current, a third frequency component (c3) having a frequency called resonance frequency (f0) of said pillar (40),

- generating (110) a plurality of second electric currents (C2), each pillar (40) of the first set (E1) being passed through by a second respective current (C2) in the stacking direction (Z),
- exciting (130), by the coupling member (25), each pillar (40) of the first set (E1) with an electromagnetic field (EM) having the first frequency (f1), the ratio between twice the resonance frequency (f0) of each pillar (40) of the first set (E1) and the first frequency (f1) being equal, to within ten percent, to a first natural integer (n1),
- generating (140), by each pillar (40) of the first set (E1), a second frequency component (c2) in the second respective current (C2), and
- supplying (150), with each second current (C2), a corresponding electrical device via a respective output conductor (35).

2. The method according to claim 1, wherein each pillar (40) has a first dimension in a first direction (X) and a second dimension in a second direction (Y) perpendicular to the first direction (X), the first direction (X) and the second direction (Y) each being perpendicular to the stacking direction (Z),
the first dimension and the second dimension each being strictly between 20 nanometers and 5 micrometers.

3. The method according to claim 1 or 2, wherein the first material (M1) has a first magnetization (A1), the method further comprising a step (120) for temporal variation of the first magnetization (A1) of the free layer (75) of at least one pillar (40), with the resonance frequency (f0) of the corresponding pillar (40).

4. The method according to any one of claims 1 to 3, wherein the first frequency component (c1) has a first amplitude (a1), the second frequency component (c2) has a second amplitude (a2), and a transfer function (F) is defined for each pillar (40) as being the ratio, in absolute value, of the first amplitude (a1) and the second amplitude (a2), the transfer function (F) being a function at least of the first frequency (f1) and having a plurality of local maxima, each local maximum corresponding to a third frequency (f3) equal, to within ten percent, to the ratio between twice the resonance frequency (f0) of the pillar and a second natural integer (n2).

5. The method according to any one of claims 1 to 4, wherein the resonance frequency (f0) of each pillar (40) of the first set (E1) is equal to the resonance frequency (f0) of each other pillar (40) of the first set (E1), the first natural integer (n1) preferably being equal to one.

6. The method according to claim 5, wherein the frequency distributor further includes (10) a second set (E2) of pillars, the resonance frequency (f0) of each pillar (40) of the second set (E2) being identical to the resonance frequency (f0) of each other pillar (40) of the second set (E2), for each pillar (40) of the second set (E2), the difference between the resonance frequency (f0) of a pillar (40) of the second set (E2) and the resonance frequency (f0) of a pillar of the first set (E1) being greater in absolute value than ten percent of the resonance frequency (f0) of each pillar (40) of the first set (E1).

7. The method according to any one of claims 1 to 4, wherein the first set (E1) includes at least one first pillar (40) having a first resonance frequency (f0) and a second pillar (40) having a second resonance frequency (f0),
the ratio between twice the first resonance frequency (f0) and the first frequency (f1) being equal, to within ten percent, to a third natural integer (n3), and
the ratio between twice the second resonance frequency (f0) and the first frequency (f1) being equal, to within ten percent, to a fourth natural integer (n4) different from the third natural integer (n3).

8. The method according to any one of claims 1 to 7, wherein the first material (M1) comprises at least one element chosen from the group made up of Co, Ni and Fe.

9. The method according to any one of claims 1 to 8, wherein the coupling member (25) comprises an electric coupling conductor (47) configured to be traveled by the first current (C1), the coupling conductor (47) and at least one pillar (40) being superimposed in the stacking direction (Z).

10. The method according to any one of claims 1 to 9, wherein each pillar (40) is cylindrical with a circular base, each pillar (40) having a generatrix parallel to the stacking direction (Z).

## FIG.1

<u>FIG.2</u>

EP 3 526 871 B1

100 ⌐⎯⎯⎯⎯⎯⎯⎯⎯⎯⎯⎯⎯⎯⎯⎯⎯⎯⎯⎯⎯⎯⎯⎯⎯⎯⎯⎯

110 ⌐⎯⎯⎯⎯⎯⎯⎯⎯⎯⎯⎯⎯⎯⎯⎯⎯⎯⎯⎯⎯⎯⎯⎯⎯⎯⎯⎯

120 ⌐⎯⎯⎯⎯⎯⎯⎯⎯⎯⎯⎯⎯⎯⎯⎯⎯⎯⎯⎯⎯⎯⎯⎯⎯⎯⎯⎯

130 ⌐⎯⎯⎯⎯⎯⎯⎯⎯⎯⎯⎯⎯⎯⎯⎯⎯⎯⎯⎯⎯⎯⎯⎯⎯⎯⎯⎯

140 ⌐⎯⎯⎯⎯⎯⎯⎯⎯⎯⎯⎯⎯⎯⎯⎯⎯⎯⎯⎯⎯⎯⎯⎯⎯⎯⎯⎯

150 ⌐⎯⎯⎯⎯⎯⎯⎯⎯⎯⎯⎯⎯⎯⎯⎯⎯⎯⎯⎯⎯⎯⎯⎯⎯⎯⎯⎯

## FIG.3

## RÉFÉRENCES CITÉES DANS LA DESCRIPTION

**Documents brevets cités dans la description**

- FR 2977999 A1
- FR 3014205 A1